(19) Europäisches Patentamt
European Patent Office
Office européen des brevets

(11) **EP 3 771 946 A1**

# (12) EUROPEAN PATENT APPLICATION

(43) Date of publication:
**03.02.2021 Bulletin 2021/05**

(51) Int Cl.:
*G03F 7/00* (2006.01)   *F28F 13/18* (2006.01)

(21) Application number: **19382655.9**

(22) Date of filing: **30.07.2019**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicants:
• **Fundació Institut Català de Nanociència i
Nanotecnologia (ICN2)**
**08193 Bellaterra (ES)**
• **Institució Catalana De Recerca I
Estudis Avançats (ICREA)**
**08010 Barcelona (ES)**

(72) Inventors:
• **JARAMILLO FERNANDEZ, Juliana**
**08193 BELLATERRA (ES)**
• **KEHAGIAS, Nikolaos**
**08193 BELLATERRA (ES)**
• **FRANCONE, Achille**
**08193 BELLATERRA (ES)**
• **SOTOMAYOR TORRES, Clivia Marfa**
**08193 BELLATERRA (ES)**

(74) Representative: **Ponti & Partners, S.L.P**
**C. de Consell de Cent 322**
**08007 Barcelona (ES)**

(54) **A MICROSTRUCTURED FILM COMPRISING INORGANIC-ORGANIC HYBRID POLYMERS, A METHOD FOR MANUFACTURING THEREOF AND A METHOD FOR COOLING THE SURFACE OF AN ELEMENT BY APPLYING SAID MICROSTRUCTURED FILM**

(57)   The present invention relates to a microstructured film comprising or consisting of or consisting essentially of inorganic-organic hybrid polymers over a substrate. The present invention also relates to a method for manufacturing said microstructured film. The present invention further relates to a method for cooling the surface of an element comprising the step of applying said microstructured film. The present invention further relates to an element comprising said microstructured film.

EP 3 771 946 A1

**Description**

**Field of the invention**

The present invention relates to a microstructured film comprising an inorganic-organic hybrid polymer which is capable to cool down and to keep clean the surface on which it is applied on.

The present invention further relates to a method for manufacturing said microstructured film and to a method for cooling the surface of an element by applying said microstructured film.

**Background of the invention**

The phenomenon of radiative cooling, and in particular using the coldness of space for terrestrial thermal management is not new [1-4], yet it was not until very recently that daytime passive cooling was achieved for a silicon (Si) absorber using a visibly transparent broadband thermal blackbody [5]. This particular thermal management solution consists of a periodic silica photonic structure. When placed on a Si absorber under sunlight, it preserves absorption of visible wavelengths while reducing the device temperature by as much as 17% due to radiative cooling.

Since then, other designs including photolithography-based photonic microstructured surfaces [6-8], polar multi-layered structures [6, 9], coatings [10, 11] and polar-polymer metamaterials on metal mirrors have been proposed [12, 13]. Very recently, a glass-polymer hybrid 80 $\mu$m-thick structure composed of randomly positioned silica spheres encapsulated by a transparent polymer has achieved a 93 W/m$^2$ cooling power density under direct sunlight [13]. Its high infrared emissivity is attributed to phonon-enhanced Frohlich resonances of the microspheres. Other groups have demonstrated temperature drops of 8 K with very simple PDMS on quartz structures, corresponding to a radiative cooling power of 127 W/m$^2$ [14].

The phenomenon of superhydrophobicity [15, 16] observed in nature includes the interaction of water with the surfaces of various plants [17] and insects [18], thus attracting researchers attention over the last years. A superhydrophobic surface generally exhibits extremely high water repellency and is characterised by a water contact angle >150° and a small hysteresis angle <15°. The most famous case for this natural effect is represented by the lotus leave were water droplets roll-off while dust particles are removed from the leaf's surface, resulting in the so-called self-cleaning effect (also known as "lotus" effect). Intensive research efforts have been placed over the last years to produce self-cleaning surfaces [19, 20].

**Brief description of the drawings**

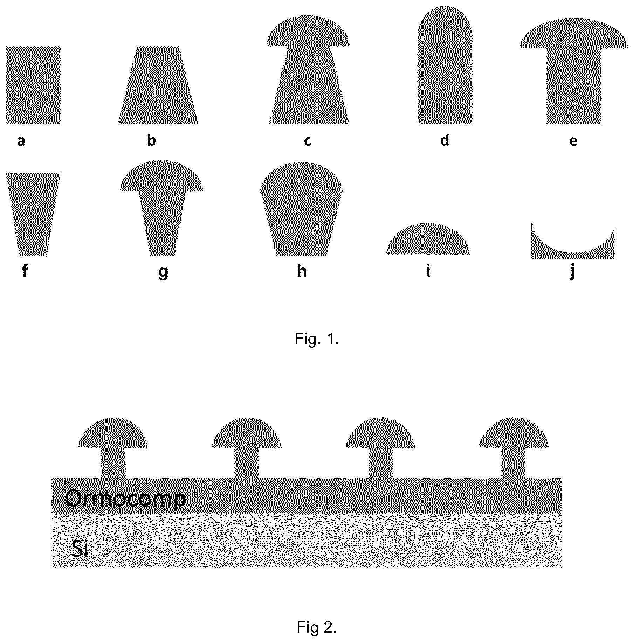

Fig. 1 Cross section schematics of exemplary structures encompassed by the present invention.

Fig. 2 Periodic pattern consisting of a plurality of structures encompassed by the present invention on a substrate (using Ormocomp® as the polymer and Si as the substrate).

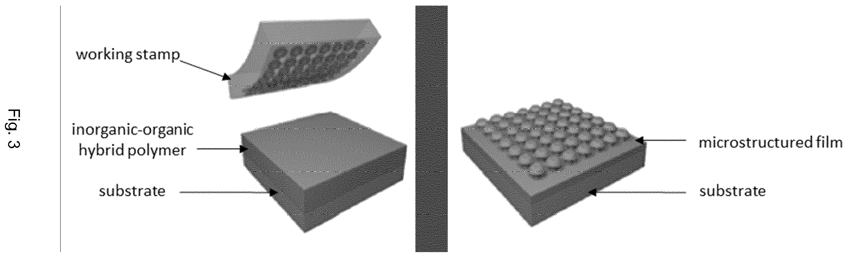

Fig. 3 Schematic flow showing the fabrication process for the microstructured film.

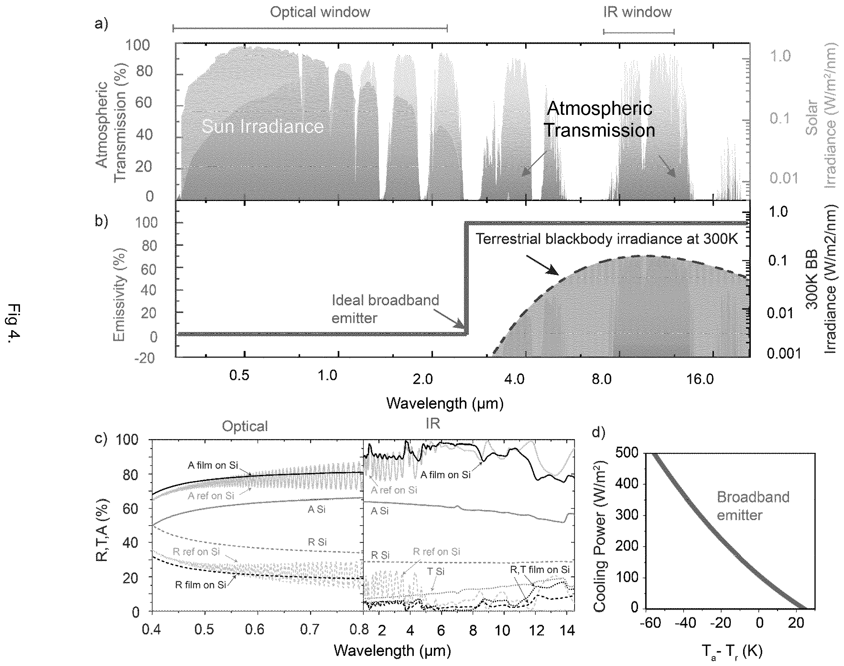

Fig. 4(a) The solar irradiance A.M 1.5 (reference spectrum at mid-latitudes with an air mass coefficient of 1.5) [21] and the atmosphere transmission calculated for Barcelona with MODTRAN (b) Spectral response of an ideal broadband radiator (continuous line), reflecting or transmitting visible and near-IR light up to 2.5 $\mu$m and re-emitting as a blackbody in the infrared spectral range. The terrestrial blackbody irradiance (at 300K) is also plotted for comparison. (c) Emissivity spectra of bulk Si and Si covered with the microstructured film. (d) Net radiative cooling power density calculated for a perfect broadband radiator considering relative temperatures between the ambient, Ta, and the radiator surface, Tr, from -60 to 30 K.

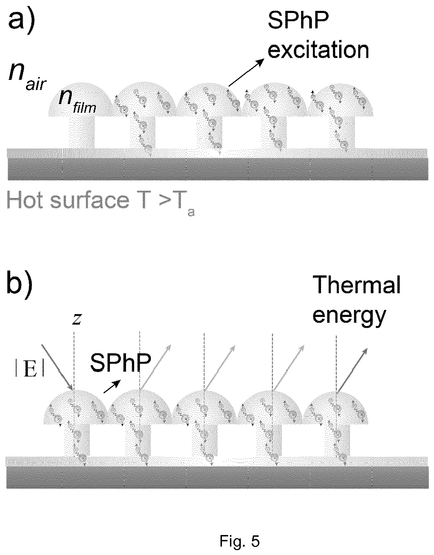

Fig. 5. Schematic representation of the radiative cooling working principle in the microstructured film used for radiative cooling. a) Thermal excitation of SPhP. Localized resonant coupling between photons and collective oscillations of dipoles. b) Heat is radiated as thermal energy due to the enhanced emissivity resulting from the gradual change in shape and the diffraction of surface phonon polaritons via the two-dimensional (2D) grating.

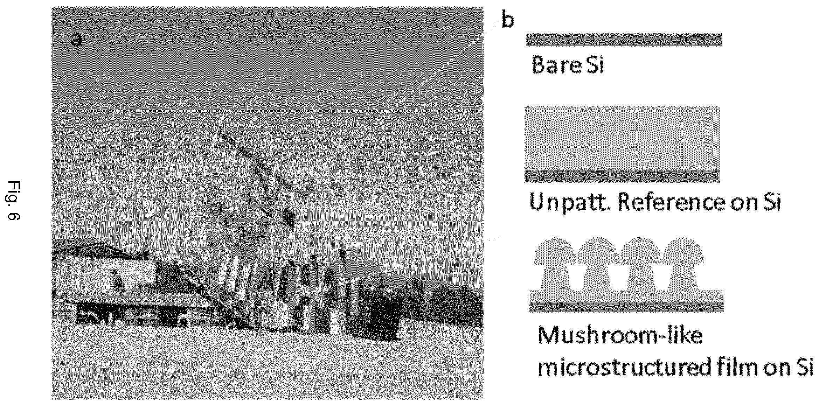

Fig. 6.a) Experimental set-up for continuous temperature measurements of a bare Si substrate, an unpatterned reference on Si and a patterned film with mushroom like structures on Si. b) Schematic illustrations of the studied samples.

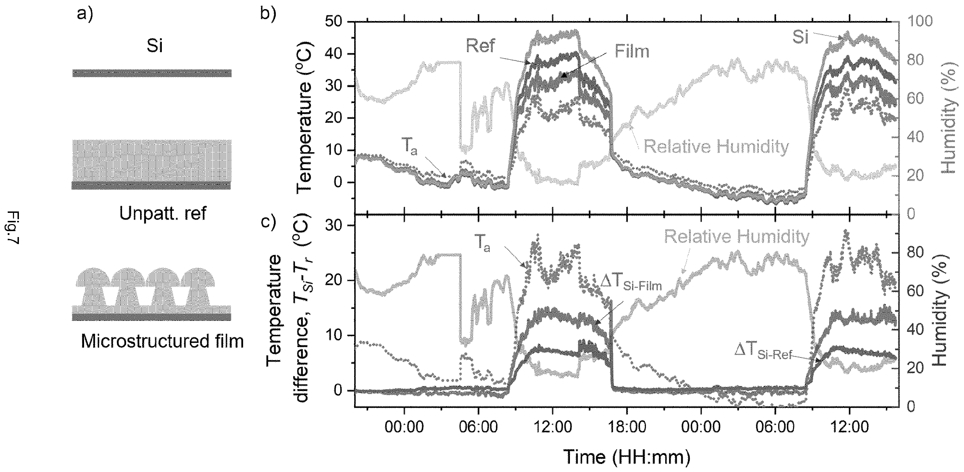

Fig. 7.a) Schematics of the studied samples. b) Measured cycle of temperature during 44 hours in a clear-sky day for the bare Si substrate, the unpatterned reference on Si, and the mushroom-type microstructured layer on Si. The evolution of the ambient temperature is plotted as a grey dotted line for reference. c) Temperature difference between the bare Si and the microstructured cooler, as well as the unpatterned reference.

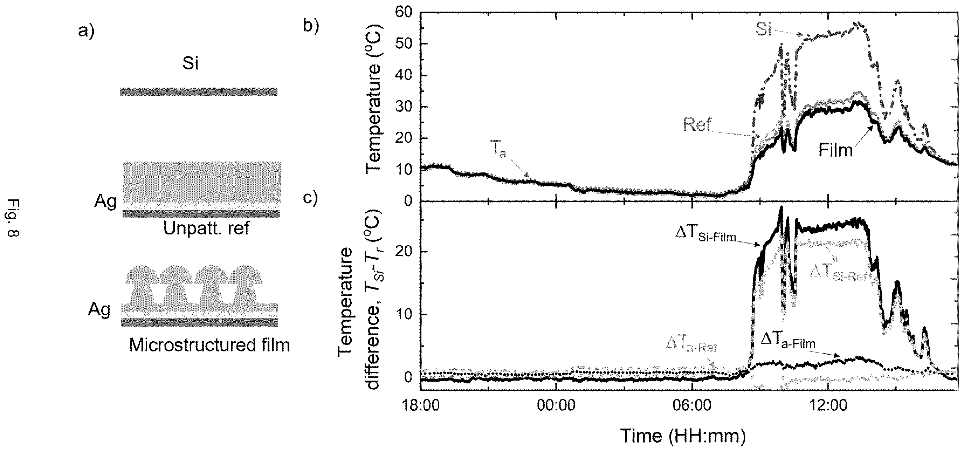

Fig. 8.a) Schematics of the studied samples backed with a silver mirror to reflect the visible light. b) Measured cycle of temperature during 24 hours in a clear-sky day for the bare Si substrate, the unpatterned reference on silver coated Si, and the mushroom-type microstructured layer on silver coated Si. The evolution of the ambient temperature is plotted as a grey dotted line for reference. c) Temperature difference between the bare Si and the microstructured cooler, as well as the unpatterned reference. The temperature difference between the ambient and the microstructured cooler, as well as the unpatterned reference is ploted as well.

## Summary of the invention

In a first aspect, the present invention relates to a microstructured film comprising or consisting of or consisting essentially of inorganic-organic hybrid polymers over a substrate.

In a second aspect, the present invention relates to a method for manufacturing a microstructured film over a substrate according to the first aspect of the invention.

In a third aspect, the present invention relates to a method for cooling the surface of an element comprising the step of applying the microstructured film according to the first aspect of the invention.

In a fourth aspect, the present invention relates to an element comprising the microstructured film according to the first aspect of the invention.

## Detailed description of the invention

The present invention relates to a microstructured film comprising an inorganic-organic hybrid polymer which is capable to cool down and to keep clean the surface on which it is applied on, in particular an exterior surface. Indeed, the present inventors have surprisingly found that this microstructured film has a dual functionality and has been proved to have a passive radiative cooling and self-cleaning properties.

Accordingly, in a first aspect of the present invention a microstructured film comprises, consists of or consists essentially of inorganic-organic hybrid polymers over a substrate, wherein the structure thereof is composed by repetitive elements having each one of the following shapes:

I) a shape which cross-section is in the form of a 4-sided polygon in which the upper side and the lower side are parallel (exemplified with letters a, b and f in figure 1);

II) a shape which cross-section is in the form of a circular segment (exemplified with letter i in figure 1);

III) a shape which cross-section is a concave plane (exemplified with letter j in figure 1);

IV) a shape which cross-section is in the form of a 4-sided polygon in which the upper side and the lower side are parallel, wherein a cross-section in the form of a circular segment is present on the upper side of the 4-sided polygon (also mentioned herein as "mushroom" like structure) (exemplified with letters c, d, e, g and h in figure 1),

and wherein the length of the lower side for shapes I) and IV), or the length of the chord defining the circular segment in shape II), or the length of the flat part of the concave plane in shape III) ranges from 0.1 $\mu$m to 100 $\mu$m, preferably from 1 $\mu$m to 50 $\mu$m and more preferably from 5 $\mu$m to 20 $\mu$m,

and wherein the distance between each element in the film ranges from 1 $\mu$m to 100 $\mu$m, preferably from 2 $\mu$m to 50 $\mu$m and more preferably from 5 $\mu$m to 20 $\mu$m,

and wherein the height of each element is lower than 100 $\mu$m and preferably lower than 20 $\mu$m.

Preferably, the aspect ratio of the structures is from 0.5 to 3 and more preferably about 1.5. The aspect ratio is defined as the width of the structure divided by the height of the structure.

In the context of the present invention, the term "comprising" refers to a composition, compound, formulation, or method that is inclusive and does not exclude additional elements or method steps. The term "comprising" also refers to a composition, compound, formulation, or method embodiments of the present disclosure that is inclusive and does not exclude additional elements or method steps.

In the context of the present invention, the term "consisting of" refers to a compound, composition, formulation, or method that excludes the presence of any additional component or method steps. The term "consisting of" also refers to a compound, composition, formulation, or method of the present disclosure that excludes the presence of any additional component or method steps.

In the context of the present invention, the term "consisting essentially of" refers to a composition, compound, formulation or method that is inclusive of additional elements or method steps that do not materially affect the characteristic(s) of the composition, compound, formulation or method. The term "consisting essentially of" also refers to a composition, compound, formulation or method of the present disclosure that is inclusive of additional elements or method steps that do not materially affect the characteristic(s) of the composition, compound, formulation, or method.

It is noted that the parameters of "length", "distance" or "height" according to their values and as used in the definition of the microstructured film according to the first aspect of the invention, can be combined irrespective of each other, i.e., by way of example, the more preferred option for the length (from 5 $\mu$m to 20 $\mu$m) can be combined with a distance between each element in the film between 1 $\mu$m and 100 $\mu$m and a height of each element lower than 100 $\mu$m.

In a preferred embodiment, the microstructured film according to the first aspect of the present invention comprising, consisting of or consisting essentially of inorganic-organic hybrid polymers comprises, consists of, consists essentially of or is derived from inorganic silicates with Si-O-Si linkages. In a more preferred embodiment, said inorganic silicates with Si-O-Si linkages are Polyhedral Oligomeric SilSesquioxanes (POSS) or Organically Modified CERamics (ORMOCER®). In an even more preferred embodiment, said inorganic-organic hybrid polymer comprises, consists of, consists essentially of or derives from Organically Modified CERamics (ORMOCER®) is ORMOCOMP®.

In the context of the present invention, the term "derives from" or "is derived from" means that the subsequent mentioned material has been subjected to any physical or chemical treatment in order to obtain the final material to be used according to an established purpose.

ORMOCER®s are inorganic-organic hybrid polymers which are synthesized in a first step by sol-gel processing. By catalytically controlled hydrolysis/polycondensation of organically modified (R'x) metal alkoxides, e. g. R'xSi(OR)4-x, a partially inorganic network is built up by the formation of organically functionalized inorganic-oxidic oligomers (sol/resin). In a second step, these can be thermally and/or photochemically (UV) cross-linked due to the organic functionalities R'x, whereas R'x can be a styryl-, methacryl-, acryl- and/or an epoxy-group. Finally, after thermal curing of the functional layers, microstructures or bulk materials are obtained (Frauenhofer Institute for Silicate Research (ISC), Würzburg, Germany). See https://www.isc.fraunhofer.de/content/dam/isc/de/documents/Publikationen/Inorganic-organic_hybrid_polymers_ORMOCER_for_micro_systems_technology.pdf)

OrmoComp® is a hybrid organic-inorganic polymer synthesized during sol-gel process and depends on ORMOCER® material class. The backbone thereof is made up of an inorganic silicate network ≡Si -O - Si≡ with single bonds between atoms. Organo(alkoxy)silanes are used as an organic crosslinking units in order to functionalize material with polymerizable groups, namely methacryloxy group [21].

In a second aspect, the present invention relates to a method for manufacturing a microstructured film over a substrate according to any of claims 1 to 5, comprising the steps of:

a) preparing a substrate, preferably Si or Si-based material, by cleaning and drying;
b) depositing an inorganic-organic hybrid polymer over the substrate prepared in step a);
c) contacting the structure obtained in step b) with polydimethylsiloxane acting as a working stamp;
d) applying low pressure between 1 and 5 bar over the assembly obtained in step c) and exposing it to UV light;
e) separating the polydimethylsiloxane from the structure formed by the inorganic-organic hybrid polymer and the Si substrate.

In particular, the microstructured film according to the present invention is fabricated using a method, namely ultraviolet light assisted nanoimprint lithography (UVNIL). Fig. 3 schematically shows the fabrication process.

In step a), a Si substrate is preferably used. This substrate is usually cleaned in IPA (isopropyl alcohol) and acetone and dried for 5 min on a hot plat at 150°C.

In step b) the inorganic-organic hybrid polymer is deposited over the substrate obtained in step a). In a preferred embodiment, independently of the other embodiments regarding other steps, for example, independently of the substrate being used, the inorganic-organic hybrid polymers comprises, consists of, consists essentially of or derives from inorganic silicates with Si-O-Si linkages. In a more preferred embodiment, said inorganic silicates with Si-O-Si linkages are Polyhedral Oligomeric SilSesquioxanes (POSS) or Organically Modified CERamics (ORMOCER®). In an even more preferred embodiment, said inorganic-organic hybrid polymer comprises, consists of, consists essentially of or derives from Organically Modified CERamics (ORMOCER®) is ORMOCOMP®.

In step c), the structure obtained in step b) is contacted with polydimethylsiloxane which contains a negative polarity of the structures to be fabricated and is used as a working stamp.

Once the structure obtained in step b) has been put into contact with polydimethylsiloxane, a low pressure is applied (between 1 and 5 bar, preferably, between 1 and 3 bar) to ensure that the polymer can uniformly spread and fill the working stamp cavities. The assembly is then exposed to UV light for few seconds (for example 3-5 sec) and finally in a further step the assembly is detached.

The present inventors have also surprisingly found that the microstructured films as defined in the first aspect of the invention have a dual functionality of radiative cooling and self-cleaning.
Accordingly, they have surprisingly found that these microstructured films could be adapted and integrated directly on a surface which requires cooling and/or as a large area adhesive film on a surface which requires this dual functionality: to be cool down and kept clean.

In a third aspect, the present invention relates to a method for cooling the surface of an element, which can be flexible or rigid, comprising the step of applying the microstructured film according to the first aspect of the invention according to any of the disclosed embodiments, alone or in combination, over said element or the surface of said element.

In a preferred embodiment, said microstructured film is directly applied over said element.

In another preferred embodiment, said microstructured film is applied over said element by means of a natural or synthetic adhesive requiring a physical curing (such as drying, pressure sensitive, contact or hot adhesives) or chemical curing (such as anaerobic, multipart, pre-mixed and frozen and one-part adhesives).

In a further preferred embodiment, said element is located outdoors, in particular facing the sky and receiving the sunlight. In a further preferred embodiment, said element is located in traffic and mobility monitoring devices, agriculture irrigation controllers, glass or plastic greenhouse, windows, building facets, building windows, automotive windows, transport, outdoor lightning, photovoltaic panels, solar panels, displays, eye glasses, airplane wings, radio-antennas, signal processing equipment, military equipment, textile clothing, thermoelectric generators units, air-conditioning units, refrigeration-units, portable vaccine coolers, medical-transport space-crafts, space instrumentation systems, nuclear-engines.

Advantageously, by applying the microstructured film of the present invention over the surface of an element as defined above, this surface is cooled down radiatively, without the use of electricity or any other means of added external energy input, due to the fact that is a passive mechanism and therefore implies no energy cost. Radiative cooling works by emitting longwave radiation through the infrared atmospheric window using outer space as a cold reservoir or heat sink.

The radiative cooling functionality is achieved due to the optical properties of the microstructured film, which exhibits a negligible absorptivity in the visible wavelength range (from 400 nm to 800 nm), and a nearly unity emissivity beyond 2.5 $\mu$m until at least 26 $\mu$m. Due to these optical characteristics, related to the patterns in the microstructured film, thermal energy is radiated from the film and passes throughout the transparent infrared window of the atmosphere (from 8 to 13 $\mu$m), exchanging heat with the outer cold space that is at a temperature of 3K. Such exchange that takes place through the IR atmospheric window due to its negligible absorption in the wavelength range from 8 $\mu$m to 13 $\mu$m, then results in cooling down the surface below said film. This cooling process may happen as well during daytime, thanks to the low absorption of the film in the visible range, which inhibits the heating of the surface due to direct incidence of sunlight, while simultaneously radiating heat at the thermal wavelengths and therefore achieving cooling passively. To illustrate this, figure 4a shows, the atmospheric transmission and the solar irradiance (1.5 A.M spectral reference [22]). Since the microstructured film does not heat up due to sunlight absorption, the heat coming from an element or surface below the microstructured film can be evacuated by radiation to the outer space as infrared thermal energy in the range between 10 $\mu$m to 13 $\mu$m (IR window) in amounts proportional to $T^4$, thus being a process very sensitive to the temperature.

The microstructured film acts as a nearly-ideal infrared broadband emitter, while preserving a high transmittance to visible light. For the sake of clarity, the spectral response of an ideal broadband infrared emitter is depicted in Fig. 4b, showing nearly perfect emissivity over the full infrared spectrum, from 2.5 to 26 $\mu$m. The microstructuration of the film provides an emissivity response shown in Fig. 4c by way of example, but not by way of limitation, that may resemble closely an ideal infrared blackbody (continuous line in Fig. 4b). The corresponding net radiative cooling power, $P_{net}$, of a surface with such optical properties at an operating temperature $T_r$ can be calculated as the sum of incoming and outgoing energy per unit time in the system [23]:

$$P_{net}(T_r, T_a) = P_r(T_r) - P_a(T_a) - P_{sun} - P_{non-rad}(T_r, T_a) \quad (1)$$

The effective radiative cooling power density calculated for an ideal broadband infrared radiator as a function of the relative temperature between the ambient, $T_a$, and the radiator, $T_r$ is plotted in Fig. 1d, showing that a power density up to 400 W/m$^2$ can be evacuated to the outer space at $T_a$-$T_r$ = -40. This represents, for example, about 35 % of the power dissipated as heat by a solar cell. Passively removing this amount of heat would translate into a relative efficiency increase up to 25 %, since solar cell efficiency is reduced by 0.5 % for every degree of temperature increase [24].

The working principle of radiative cooling via the disclosed herein microstructured film is explained as follows. The material used to fabricate the film is an inorganic-organic hybrid polymer, which is synthesized during sol-gel process and its back-bone is preferably formed from inorganic silicate Si-O-Si linkages. This type of UV curable polymer has glass-type material properties after UV curing, exhibiting highly transmittance near the ultraviolet and the visible wavelengths. Glass is mainly made of silica ($SiO_2$), which is a polar material, exhibiting a non-vanishing dipole moment. As a consequence, the electromagnetic radiation interacts with the dipoles of the ionic polar material. Bulk silica exhibits emissivity dips at around 8 um and 20 um, arising from the interaction of optical phonons and electromagnetic radiation, so-called bulk phonon-polariton resonances, which result in high reflectivity spectral regions, something rather detrimental for radiative cooling. Engineering the material surface allow us to modify the interaction between electromagnetic radiation and the collective mechanical oscillations of the dipoles at the surface of $SiO_2$ to suppress the emissivity dips that are characteristic of the unpatterned polar material. The patterning of the disclosed herein structures on the film results in decreased reflectivity and achieves an ultrahigh nearly-unity emissivity throughout all the IR wavelengths up to 26 $\mu$m,

where heat can be evacuated through the atmosphere and deposited in the outer space that acts as a big very cold heat sink.

Ultra-high infrared emissivity (beyond 2.5 $\mu$m) is achieved by combining three effects (illustrated in Fig. 5): i) the upper shape of the microstructure, ii) the thermal excitation of localized hybrid surface modes, i.e., surface phonon polaritons (SPhP) and iii) the diffraction of such excitations to the far field via the periodic lattice induced by the patterning, as explained in detail below:

i) The differential polar-dielectric boundaries from the hemispheres result in a progressive

variation of the material effective refractive index, $n_{eff} = c/dk/dw$, which is a function of wavelength and hemisphere radius, with w and k being the energy and the wavevector of the photons [25]. This yields an impedance matching between the polar and the dielectric media (silica/air) over a large spectral range [26].

ii) The undesired temperature rise generated by dissipation in a Si wafer acting as a solar

absorber, becomes a heat source to activate localized SPhP resonances in the polar hemispheres. SPhP are collective mechanical oscillations of the dipoles in the polar hemisphere that interact resonantly with photons of the same frequency. At the surface, this results in an evanescent field with high intensity and strong near field confinement. However, the effect of this surface modes is not transmitted in the far field [27, 28].

iii) By ruling a grating with period d on the interface between the polar and the dielectric media, SPhP can be outcoupled into the far-field, resulting in enhanced emissivity. Such SPhP-mediated emissivity depends on the polarization and the azimuth angle $\Omega$, according to:

$$\frac{2\pi}{\lambda} \sin\theta = \vec{q}_x + n\frac{2\pi}{d}$$

(2)

Where $q_x$ is the wavevector of the surface excitation and n is an integer. The microstructured film acts as a grating in two dimensions, where the patterned periodicity diffracts the SPhPs into the far field, thus further enhancing the emissivity, even at high incident angles.

In this way, the heat dissipated by the surface to be cooled is evacuated as thermal radiation optimised to pass through the transparent infrared atmospheric window via surface engineering.

In a fourth aspect, the present invention relates to an element comprising the microstructured film according to the first aspect of the invention in any of the disclosed embodiments, alone or in combination. In a preferred embodiment, said element is located outdoors, in particular facing the sky and directly receiving the sunlight. In a more preferred embodiment, said element is located in traffic and mobility monitoring devices, agriculture irrigation controllers, glass or plastic greenhouse, windows, building facets, building windows, automotive windows, transport, outdoor lightning, photovoltaic panels, solar panels, displays, eye glasses, airplane wings, radio-antennas, signal processing equipment, military equipment, textile clothing, thermoelectric generators units, air-conditioning units, refrigeration-units, portable vaccine cooler, medical-transport space-crafts, space instrumentation systems, nuclear-engines.

**EXAMPLES**

To experimentally test the radiative cooling effect of the microstructured film of the present invention, a specific experiment was designed, consisting of simultaneously measuring the temperature of a Si slab, $T_{Si}$, which is compared to the temperature of a Si slab coated with the reference unpatterned film of ORMOCOMP®, $T_{ref}$, and another Si wafer coated with the microstructured film of the present invention, $T_{film}$. The temperature measurement is performed by using 4-point resistive thermometers (PT100) attached to the backside of the Si substrates with silver paste to ensure an excellent thermal contact. The three embodiments faced the sky and during daylight hours they were exposed to direct sunlight. Standard 550 um-thick boron-doped Si wafers were used as substrates, as an example case, acting as solar absorbers. The experimental set-up and schematic illustrations of the studied samples and their configurations are shown in Fig. 6a and b, respectively.

The following Examples are offered for illustrative purposes only and are not intended to limit the scope of the present invention in any way.

**Example 1:**

A 44h continuous temperature measurement that serves to demonstrate the radiative cooling effect of the mushroom-type microstructured film is shown in Fig. 7. The bare Si substrate heats up during daylight hours due to sunlight absorption, reaching a maximal temperature of 47.3 C at 1:45pm. Both the reference and the microstructured film of the present invention (mushroom type for example) keep the Si substrate at lower temperature, particularly during daytime, compared to the bare Si substrate, demonstrating radiative cooling.

Since Ormocomp and the patterned film are highly transparent in the range from 400 nm to 800 nm, sunlight passes through and is absorbed by the Si substrate heating it up above the ambient. As shown in Fig. 4d, a broadband radiative cooler such as our microstructured film evacuates heat with a higher net power density as its temperature is much greater than the ambient, $T_a$-$T_r$ << 0. For that reason, the microstructure coating evacuates heat more efficiently from 10 am to 4 pm. Fig. 7c also shows that when the Si wafer is coated with the mushroom-type microstructured film, its temperature is lowered by an average of 13 degrees during daytime, as the system reaches its steady state operation temperature. In comparison, the unpatterned reference coating cools down the Si substrate by only 7 degrees. This experiment demonstrates the radiative cooling efficiency of the film.

The measured relative humidity is plotted on the right axis. Although atmospheric water vapor reduces the atmospheric transmittance and therefore reduces the radiative cooling efficiency, here the oscillations in $T_{Si}$-$T_r$ are mostly due to temperature variations and not to the actual moisture content of the atmosphere. Relative humidity changes happen slowly with time, and thus it is assumed to not introduce changes in the thermal conductivity and dissipation properties of the metamaterial.

**Example 2:**

A measurement (similar to that included in Example 1) is performed on silver coated Si substrates (Fig.8a). For this experimental configuration the unpatterned reference and the microstructured film cover the surface of the silver-coated Si substrate. The samples faced the sky during a clear day-and-night cycle and the results are plotted in fig. 8b. When a silver-coated Si slab is covered with the patterned film and exposed to direct sunlight, average below-ambient radiative cooling at 2.5°C is achieved, which means that particular structures can keep a surface 2.5°C cooler than the ambient temperature, passively-without requiring electricity input or any other means of added energy. Furthermore, the silver coating reflects most of the incident solar radiation, thus lowering the temperature of the Si slab by 21.6 C in average, from 10:45 am and 12:45, when the system reach a steady state temperature.

In addition to the passive radiative cooling a water repelling functionality is achievable allowing the surfaces to be self-cleaned. This is of particular interest for applications such as photovoltaic panels and building windows which require to have a clean surface for maximum performance.

**References**

[1] Orel, B., Gunde, M. K. and Krainer, A., Radiative cooling efficiency of white pigmented paints. Solar Energy 50, 477-482 (1993).

[2] Catalanotti, S., Cuomo, V., Piro, G., Ruggi, D., Silvestrini, V., Troise, G., The radiative cooling of selective surfaces. Solar Energy 17, 83-89 (1975).

[3] Gueymard, C. A., Myers, D. and Emery K., Proposed reference irradiance spectra for solar energy systems testing. Solar Energy 73, 443-467 (2002).

[4] Granqvist, C. G., Radiative heating and cooling with spectrally selective surfaces. Applied Optics 20, 2606-2615 (1981).

[5] Zhu, L., Raman, A. P. and Fan, S., Radiative cooling of solar absorbers using a visibly transparent photonic crystal thermal blackbody. Proceedings of the National Academy of Sciences, 112 (40), 12282-12287 (2015).

[6] Raman, A. P., Anoma, M. A., Zhu, L., Rephaeli, E. and Fan, S., Passive radiative cooling below ambient air temperature under direct sunlight. Nature 515, 540-544 (2014).

[7] Zhu, L., Raman, A., Wang, K. X., Anoma, M. A. and Fan, S., Radiative cooling of solar cells. Optica 1, 32-38 (2014).

[8] Zhou, Z., Sun, X. and Bermel, P., Radiative cooling for thermophotovoltaic systems. Infrared Remote Sensing and Instrumentation XXIV 9973(01)-9973(08) (2016).

[9] Tsu, R. and Hernandez, J. G., Temperature dependence of silicon Raman lines. Applied Physics Letters 41, 1016-1018 (1982).

[10] Gentle, A. R. and Smith, G. B., A subambient open roof surface under the Mid-Summer sun. Advanced Science 2, 1500119(1)-1500119(4) (2015).

[11] Peng, Y. et al., Large-scale radiative cooling fabric. Nature Sustainability 1, 105-112 (2018).

[12] Zhai, Y., Ma Y., Sabrina, D., Zhao, D., Lou, R., Tan, G., Yang, R. and Yin X., Scalable-manufactured randomized glass-polymer hybrid metamaterial for daytime radiative cooling. Science 335 (6329), 1062-1066, (2017).

[13] Mandal, J. et al., Hierarchically porous polymer coatings for highly efficient passive daytime radiative cooling. Science, 362 (6412), 315-319 (2018).

[14] Kou, J., Jurado, Z., Chen, Z., Fan, S. and Minnich, A. J., Daytime radiative cooling using near-black infrared emitters, ACS Photonics, 4, 626-630 (2017).

[15] Cassie, A. B. D., Baxter, S., Wettability of porous surfaces. Transactions of the Faraday Society, 40 (0), 546-551 (1944).

[16] Wenzel, R. N., Resistance of Solid Surfaces to wetting by water. Industrial & Engineering Chemistry, 28 (8), 988-994 (1936).

[17] Wu, Y., Hang, T., Yu, Z., Xu, L., Li, M., Lotus leaf-like dual-scale silver film applied as a superhydrophobic and self-cleaning substrate. Chemical communications, 50 (61), 8405-840 (2014).

[18] Wang, D., Zhao, A., Li, L., He, Q., Guo, H., Sun, H., Gao, Q., Bioinspired ribbed hair arrays with robust superhydrophobicity fabricated by micro/nanosphere lithography and plasma etching. RSC Advances, 5 (117), 96404-96411 (2015).

[19] Sahoo, B. N., Kandasubramanian, B., Recent progress in fabrication and characterisation of hierarchical biomimetic superhydrophobic structures. RSC Advances, 4 (42), 22053-22093 (2014).

[20] Valipour M, N., Birjandi, F. C., Sargolzaei, J., Super-non-wettable surfaces. A review. Colloids and Surfaces A: Physicochemical and Engineering Aspects, 448 (0), 93-106 (2014).

[21] Zukauskas, A., Bataviciute, G., Sciuka, M., Jukna, T., Melninkaitis, A. and Malinauskas, M., Characterization of photopolymers used in laser 3D micro/nanolithography by means of laser-induced damage threshold (LIDT). Optical Materials Express, 4 (8),1601-1616 (2014).

[22] ASTM. G173 - 03 Standard Tables for Reference Solar Spectral Irradiances: Direct Normal and Hemispherical on 37 Tilted Surface. ASTM International, 2012. doi: 10. 1520/G0173-03R12.2.

[23] Granqvist, C. G. and Hjortsberg, A., Surfaces for radiative cooling: Silicon monoxide films on aluminum. Applied Physics Letters 36, 139-141 (1980).

[24] Gueymard, C. A., Myers, D. and Emery, K., Proposed reference irradiance spectra for solar energy systems testing. Solar Energy, 73(6), 443-467 (2002).

[25] Lopez, C., Three-dimensional photonic bandgap materials: semiconductors for light. Journal of Optics A: Pure and Applied Optics, 8(5), R1-R14 (2006).

[26] Zhu, L., Raman, A., Xingze Wang, K., Abou Anoma, M. and Fan, S., Radiative cooling of solar cells. Optica, 1(1), 32-38 (2014).

[27] Frohlich, H., Theory of dielectrics: dielectric constant and dielectric loss. Oxford, Clarendon Press, 1949.

[28] Zhai, Y., Ma, Y., David, S. N., Zhao, D., Lou, R., Tan, G., Yang, R. and Yin, X., Scalable-manufactured randomized glass-polymer hybrid metamaterial for daytime radiative cooling. Science, 335(6329), 1062-1066 (2017).

**Claims**

1. A microstructured film comprising inorganic-organic hybrid polymers over a substrate, wherein the structure thereof is composed by repetitive elements having each one of the following shapes:

    I) a shape which cross-section is in the form of a 4-sided polygon in which the upper side and the lower side are parallel;
    II) a shape which cross-section is in the form of a circular segment;
    III) a shape which cross-section is a concave plane;
    IV) a shape which cross-section is in the form of a 4-sided polygon in which the upper side and the lower side are parallel, wherein a cross-section in the form of a circular segment is present on the upper side of the 4-sided polygon,

    and wherein the length of the lower side for shapes I) and IV), or the length of the chord defining the circular segment in shape II), or the length of the flat part of the concave plane in shape III) ranges from 0.1 $\mu$m to 100 $\mu$m,
    and wherein the distance between each element in the film ranges from 1 $\mu$m to 100 $\mu$m, and wherein the height of each element is lower than 100 $\mu$m.

2. A microstructured film consisting of inorganic-organic hybrid polymers over substrate, wherein the structure thereof is composed by repetitive elements having each one of the following shapes:

    I) a shape which cross-section is in the form of a 4-sided polygon in which the upper side and the lower side are parallel;
    II) a shape which cross-section is in the form of a circular segment;
    III) a shape which cross-section is a concave plane;
    IV) a shape which cross-section is in the form of a 4-sided polygon in which the upper side and the lower side are parallel, wherein a cross-section in the form of a circular segment is present on the upper side of the 4-sided polygon,

    and wherein the length of the lower side for shapes I) and IV), or the length of the chord defining the circular segment in shape II), or the length of the flat part of the concave plane in shape III) ranges from 0.1 $\mu$m to 100 $\mu$m,
    and wherein the distance between each element in the film ranges from 1 $\mu$m to 100 $\mu$m, and wherein the height of each element is lower than 100 $\mu$m.

3. The microstructured film according to claim 1 or 2, wherein said inorganic-organic hybrid polymers comprises inorganic silicates with Si-O-Si linkages.

4. The microstructured film according to claim 3, wherein said inorganic-organic hybrid polymers comprising inorganic silicates with Si-O-Si linkages are Polyhedral Oligomeric SilSesquioxanes (POSS) or Organically Modified CERamics (ORMOCER®).

5. The microstructured film according to claim 4, wherein said inorganic-organic hybrid polymer derives from Organically Modified CERamics (ORMOCER®) is ORMOCOMP®.

6. A method for manufacturing a microstructured film over a substrate according to any of claims 1 to 5, comprising the steps of:

    a) preparing a substrate by cleaning and drying;
    b) depositing an inorganic-organic hybrid polymer over the substrate prepared in step a);
    c) contacting the structure obtained in step b) with polydimethylsiloxane acting as a working stamp;
    d) applying low pressure between 1 and 5 bar over the assembly obtained in step c) and exposing it to UV light;
    e) separating the polydimethylsiloxane from the structure formed by the inorganic-organic hybrid polymer and the substrate.

7. The method according to claim 6, wherein said inorganic-organic hybrid polymers comprises inorganic silicates with Si-O-Si linkages.

8. The method according to claim 7, wherein said inorganic-organic hybrid polymers comprising inorganic silicates with Si-O-Si linkages are Polyhedral Oligomeric SilSesquioxanes (POSS) or Organically Modified CERamics (ORMOCER®).

9. The microstructured film according to claim 8, wherein said inorganic-organic hybrid polymer derived from Organically Modified CERamics (ORMOCER®) is ORMOCOMP®.

10. A method for cooling the surface of an element, comprising the step of applying the microstructured film according to any of claims 1 to 5 over said element.

11. The method according to claim 10, wherein said microstructured film is directly applied over said element.

12. The method according to claim 10, wherein said microstructured film is applied over said element by means of a natural or synthetic adhesive requiring a physical or chemical curing.

13. The method according to any of claims 10 to 12, wherein said element is located outdoors.

14. The method according to any of claims 10 to 13, wherein said element is located in traffic and mobility monitoring devices, agriculture irrigation controllers, glass or plastic greenhouse, windows, building facets, building windows, automotive windows, transport, outdoor lightning, photovoltaic panels, solar panels, displays, eye glasses, airplane wings, radio-antennas, signal processing equipment, military equipment, textile clothing, thermoelectric generators units, air-conditioning units, refrigeration-units, portable vaccine cooler, medical-transport space-crafts, space instrumentation systems, nuclear-engines.

15. An element comprising the microstructured film according to any of claims 1 to 5.

16. The element according to claim 15, which is located outdoors.

17. The element according to claim 15 or 16, which is located in traffic and mobility monitoring devices, agriculture irrigation controllers, glass or plastic greenhouse, windows, building facets, building windows, automotive windows, transport, outdoor lightning, photovoltaic panels, solar panels, displays, eye glasses, airplane wings, radio-antennas, signal processing equipment, military equipment, textile clothing, thermoelectric generators units, air-conditioning units, refrigeration-units, portable vaccine cooler, medical-transport space-crafts, space instrumentation systems, nuclear-engines.

Fig. 1.

Fig 2.

microstructured film

substrate

working stamp

inorganic-organic
hybrid polymer

substrate

Fig. 3

Fig 4.

a)

SPhP
excitation

$n_{air}$

$n_{film}$

Hot surface T >T$_a$

b)

Thermal
energy

$z$

|E|

SPhP

Fig. 5

Fig. 6

Fig.7

Fig. 8

EP 3 771 946 A1

Europäisches
Patentamt

European
Patent Office

Office européen
des brevets

## EUROPEAN SEARCH REPORT

Application Number

EP 19 38 2655

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/052241 A1 (KING WILLIAM P [US] ET AL) 1 March 2012 (2012-03-01)<br>* figure 11 *<br>* page 7, paragraph 94 * | 1-3, 15-17 | INV.<br>G03F7/00<br>F28F13/18 |
| X | JACOT-DESCOMBES: "Organic-inorganic-hybrid-polymer microlens arrays with tailored optical characteristics and multi-focal properties",<br>OPTICS EXPRESS,<br>vol. 23, no. 19,<br>18 September 2015 (2015-09-18), page 25365, XP055662870,<br>DOI: 10.1364/OE.23.025365<br>* step 3;<br>figure 1 *<br>* figures 3, 6 * | 1,3-5, 15-17 | |
| X | Anon.: "UV-Curable Hybrid Polymers for Micro Optical Components",<br>,<br>1 July 2015 (2015-07-01), XP055662170,<br>Retrieved from the Internet:<br>URL:https://www.microresist.de/sites/defau lt/files/download/flyer_hybrid_polymers_Ju ly2015.pdf<br>[retrieved on 2020-01-27]<br>* page 2 * | 1-9 | TECHNICAL FIELDS SEARCHED (IPC)<br><br>G02B<br>H05G<br>G21K<br>G03F<br>F28F |
| A | JP 2018 095488 A (DEXERIALS CORP ET AL.) 21 June 2018 (2018-06-21)<br>* claim 1 *<br>* figure 6 * | 1-17 | |

-/--

The present search report has been drawn up for all claims

| Place of search | Date of completion of the search | Examiner |
|---|---|---|
| Munich | 30 January 2020 | Le Masson, Nicolas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

**EUROPEAN SEARCH REPORT**

Application Number

EP 19 38 2655

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2019/130199 A1 (3M INNOVATIVE PROPERTIES CO [US]) 4 July 2019 (2019-07-04) * claim 1 * * figure 6 * | 1-17 | |
| A | EDEN REPHAELI ET AL: "Ultrabroadband Photonic Structures To Achieve High-Performance Daytime Radiative Cooling", NANO LETTERS, 11 March 2013 (2013-03-11), XP055414069, US ISSN: 1530-6984, DOI: 10.1021/nl4004283 * the whole document * | 1-17 | |

TECHNICAL FIELDS
SEARCHED      (IPC)

The present search report has been drawn up for all claims

| Place of search | Date of completion of the search | Examiner |
|---|---|---|
| Munich | 30 January 2020 | Le Masson, Nicolas |

CATEGORY OF CITED DOCUMENTS

X : particularly relevant if taken alone
Y : particularly relevant if combined with another
　 document of the same category
A : technological background
O : non-written disclosure
P : intermediate document

T : theory or principle underlying the invention
E : earlier patent document, but published on, or
　 after the filing date
D : document cited in the application
L : document cited for other reasons

& : member of the same patent family, corresponding
　 document

EPO FORM 1503 03.82 (P04C01)

## ANNEX TO THE EUROPEAN SEARCH REPORT
## ON EUROPEAN PATENT APPLICATION NO.

EP 19 38 2655

This annex lists the patent family members relating to the patent documents cited in the above-mentioned European search report.
The members are as contained in the European Patent Office EDP file on
The European Patent Office is in no way liable for these particulars which are merely given for the purpose of information.

30-01-2020

| Patent document cited in search report | | Publication date | Patent family member(s) | | Publication date |
|---|---|---|---|---|---|
| US 2012052241 | A1 | 01-03-2012 | CA | 2752798 A1 | 26-08-2010 |
| | | | CN | 102387915 A | 21-03-2012 |
| | | | EP | 2398638 A1 | 28-12-2011 |
| | | | JP | 2012517910 A | 09-08-2012 |
| | | | KR | 20110139228 A | 28-12-2011 |
| | | | US | 2012052241 A1 | 01-03-2012 |
| | | | US | 2017144202 A1 | 25-05-2017 |
| | | | WO | 2010096073 A1 | 26-08-2010 |
| JP 2018095488 | A | 21-06-2018 | NONE | | |
| WO 2019130199 | A1 | 04-07-2019 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **OREL, B. ; GUNDE, M. K. ; KRAINER, A.** Radiative cooling efficiency of white pigmented paints. *Solar Energy,* 1993, vol. 50, 477-482
- **CATALANOTTI, S. ; CUOMO, V. ; PIRO, G. ; RUGGI, D. ; SILVESTRINI, V. ; TROISE, G.** The radiative cooling of selective surfaces. *Solar Energy,* 1975, vol. 17, 83-89
- **GUEYMARD, C. A. ; MYERS, D. ; EMERY K.** Proposed reference irradiance spectra for solar energy systems testing. *Solar Energy,* 2002, vol. 73, 443-467
- **GRANQVIST, C. G.** Radiative heating and cooling with spectrally selective surfaces. *Applied Optics,* 1981, vol. 20, 2606-2615
- **ZHU, L. ; RAMAN, A. P. ; FAN, S.** Radiative cooling of solar absorbers using a visibly transparent photonic crystal thermal blackbody. *Proceedings of the National Academy of Sciences,* 2015, vol. 112 (40), 12282-12287
- **RAMAN, A. P. ; ANOMA, M. A. ; ZHU, L. ; REPHAELI, E. ; FAN, S.** Passive radiative cooling below ambient air temperature under direct sunlight. *Nature,* 2014, vol. 515, 540-544
- **ZHU, L. ; RAMAN, A. ; WANG, K. X. ; ANOMA, M. A. ; FAN, S.** Radiative cooling of solar cells. *Optica,* 2014, vol. 1, 32-38
- **ZHOU, Z. ; SUN, X. ; BERMEL, P.** Radiative cooling for thermophotovoltaic systems. *Infrared Remote Sensing and Instrumentation,* 2016, vol. XXIV, 9973
- **TSU, R ; HERNANDEZ, J. G.** Temperature dependence of silicon Raman lines. *Applied Physics Letters,* 1982, vol. 41, 1016-1018
- **GENTLE, A. R. ; SMITH, G. B.** A subambient open roof surface under the Mid-Summer sun. *Advanced Science,* 2015, vol. 2, 1500119
- **PENG, Y. et al.** Large-scale radiative cooling fabric. *Nature,* 2018, vol. 1, 105-112
- **ZHAI, Y. ; MA Y. ; SABRINA, D. ; ZHAO, D. ; LOU, R. ; TAN, G. ; YANG, R. ; YIN X.** Scalable-manufactured randomized glass-polymer hybrid metamaterial for daytime radiative cooling. *Science,* 2017, vol. 335 (6329), 1062-1066
- **MANDAL, J. et al.** Hierarchically porous polymer coatings for highly efficient passive daytime radiative cooling. *Science,* 2018, vol. 362 (6412), 315-319

- **KOU, J. ; JURADO, Z. ; CHEN, Z. ; FAN, S. ; MINNICH, A. J.** Daytime radiative cooling using near-black infrared emitters. *ACS Photonics,* 2017, vol. 4, 626-630
- **CASSIE, A. B. D. ; BAXTER, S.** Wettability of porous surfaces. *Transactions of the Faraday Society,* 1944, vol. 40 (0), 546-551
- **WENZEL, R. N.** Resistance of Solid Surfaces to wetting by water. *Industrial & Engineering Chemistry,* 1936, vol. 28 (8), 988-994
- **WU, Y. ; HANG, T. ; YU, Z. ; XU, L. ; LI, M.** Lotus leaf-like dual-scale silver film applied as a superhydrophobic and self-cleaning substrate. *Chemical communications,* 2014, vol. 50 (61), 8405-840
- **WANG, D. ; ZHAO, A. ; LI, L. ; HE, Q. ; GUO, H. ; SUN, H. ; GAO, Q.** Bioinspired ribbed hair arrays with robust superhydrophobicity fabricated by micro/nanosphere lithography and plasma etching. *RSC Advances,* 2015, vol. 5 (117), 96404-96411
- **SAHOO, B. N. ; KANDASUBRAMANIAN, B.** Recent progress in fabrication and characterisation of hierarchical biomimetic superhydrophobic structures. *RSC Advances,* 2014, vol. 4 (42), 22053-22093
- **VALIPOUR M, N. ; BIRJANDI, F. C. ; SARGOLZAEI, J.** Super-non-wettable surfaces. *A review. Colloids and Surfaces A: Physicochemical and Engineering Aspects,* 2014, vol. 448 (0), 93-106
- **ZUKAUSKAS, A. ; BATAVIČIUTĖ, G. ; ŠCIUKA, M. ; JUKNA, T. ; MELNINKAITIS, A. ; MALINAUSKAS, M.** Characterization of photopolymers used in laser 3D micro/nanolithography by means of laser-induced damage threshold (LIDT). *Optical Materials Express,* 2014, vol. 4 (8), 1601-1616
- **GRANQVIST, C. G. ; HJORTSBERG, A.** Surfaces for radiative cooling: Silicon monoxide films on aluminum. *Applied Physics Letters,* 1980, vol. 36, 139-141
- **GUEYMARD, C. A. ; MYERS, D. ; EMERY, K.** Proposed reference irradiance spectra for solar energy systems testing. *Solar Energy,* 2002, vol. 73 (6), 443-467
- **LOPEZ, C.** Three-dimensional photonic bandgap materials: semiconductors for light. *Journal of Optics A: Pure and Applied Optics,* 2006, vol. 8 (5), R1-R14
- **ZHU, L. ; RAMAN, A. ; XINGZE WANG, K. ; ABOU ANOMA, M. ; FAN, S.** Radiative cooling of solar cells. *Optica,* 2014, (1), 32-38

- **FROHLICH, H.** Theory of dielectrics: dielectric constant and dielectric loss. Clarendon Press, 1949

- **ZHAI, Y. ; MA, Y. ; DAVID, S. N. ; ZHAO, D. ; LOU, R. ; TAN, G. ; YANG, R. ; YIN, X.** Scalable-manufactured randomized glass-polymer hybrid metamaterial for daytime radiative cooling. *Science,* 2017, vol. 335 (6329), 1062-1066